# EUROPEAN PATENT APPLICATION

(11) **EP 2 207 407 A1**
(43) Date of publication of application: **14.07.2010**
(21) Application number: 09000375.7
(22) Date of filing: 13.01.2009
(51) Int. Cl.: H05K 3/10

(54) **Method for generation of electrically conducting surface structures, device and use**

(71) Applicant: Stichting Dutch Polymer Institute, 5612 AB Eindhoven (NL)
(72) Inventor: The designation of the inventor has not yet been filed
(74) Representative: Ackermann, Joachim

(57) **Abstract**

Disclosed is a method and a device for generating conductive surface patterns on a substrate by coating the substrate with a metal precursor and treating the coated substrate with a plasma to release metal from the metal precursor.

The process is easy to implement, needs only low energy, is fast and can be used to generate electrically conductive patterns at low cost.

## Description

This invention relates to the manufacture of electrically conducting surface patterns by a simple and efficient method, and to a device for performing this method as well as to the use of plasma treatment to generate electrically conducting surface patterns.

Recent research has focused on the production of good conductors for affordable circuitry and microelectronic devices for disposable electronics on low-cost substrates. While conventional thin film technologies, such as pysical vapor deposition and sputtering, are costly and incapable of accomplishing this goal, alternative techologies, such as mass and digital printing, have appeared as prospective production techniques. Within the last decades, inkjet printing has grown to a mature non-impact patterning method, producing high resolution structures at relatively high speed on large areas with a minimal amount of functional material due to its additive nature.

The printed structures need a sintering step to become conductive. The use of nanoparticles reduces the sintering temperature due to the high surface-to-volume ratio is disclosed in WO-A-2004/005,413.

Nanoparticle dispersions have been widely used for the deposition of metallic conductors, whereby silver and gold are the predominant materials due to their high conductivities. While their expedient properties for the generation of high density compacts are obvious, nanoparticle materials have to be stabilized in order to be applied reproducibly. While for nanoparticles below 10 nm the sintering temperature drops well below 300°C, the stabilizer molecules usually inhibit sintering due to their relatively high decomposition temperatures. Besides nanoparticle inks, also inks that consist of an organometallc complex are used. These inks lack stabilizing groups and, therefore, allow a lower sintering tempeature, typically between 130 and 250°C.

Although these temperatures are much lower than their bulk melting temperature, the sintering temperature is still well above the glass transition temperature of engineering polymers, like polycarbonate (PC) or common polymer foils, like polyethylene terephthalate (PET). In fact, only high performance polymer substrates, such as polytetrafluoroethylene (PTFE), polyetherether ketone (PEEK) and polyimide (PI), can be used. Moreover, commonly used polymers are favorable in terms of production costs.

Previously, particulate materials have been sintered using conventional heating, Laser sintering, microwave heating, high temperature plasma sintering, field assisted sintering and pulse electric current sintering (compare Scripta Mater. 2006, 55, 1139; Nanotechnology 2005, 16, 779; Appl. Phys. Lett. 2007, 90, 141103; WO-A-2007/039,227; Adv. Mater. 2006, 18, 2101; J. Mater. Res. 1992, 7, 2643; Mat. Res. 2004, 7, 269; J.Mater. Res. 2001, 16, 286 and Metall.Mater.Trans. A 2003, 34A, 2655). Most of these techniques are not suitable for common polymeric substrate materials due to the large overall thermal energy impact.

The heating methods disclosed so far for generating electrically conductive surface patterns increase the substrate temperature significantly, which makes these techniques not compatible with most common polymers that have a low deformation temperature.

Surprisingly it has now been found that by applying a plasma to the printed structures conductive structures can be formed at low temperatures with high efficiency.

It is an objective of the present invention to provide an improved fast, simple and cost-efficient technique that allows conversion of printed structures of metal precursors into metal structures at low temperatures thus allowing the application of substrates that could not be used with conventional techniques.

The present invention relates to a process for generating electrically conducting surface patterns on a substrate surface comprising the steps:
i) coating a surface of a substrate with a predetermined pattern of a metal precursor,
ii) exposing the coated substrate to a plasma to convert the metal precursor into the metal and to form electrically conductive patterns on said surface.

The process of this invention uses at least one plasma treatment of a metal precursor, preferably a metal salt, coated substrate to transform the metal precursor into the corresponding metal. It has been found that with metal precursor patterns upon exposure to a plasma the conversion into the metal takes place in much shorter times than with conventional heating in an oven, while at least similar or in most cases an improved conductivity has been obtained. For example, when using inkjet printed patterns of a silver salt, conductivity values of 5 % of bulk silver can be reached with standard settings and at room temperature, but with increased times and/or power the conductivity can be further improved, for example to 25 % bulk silver conductivity. With alternative sintering methods these conductivity values usually require longer sintering times and higher sintering temperatures.

In a preferred variant of the process of this invention the plasma treated coated substrate is heated in a step iii) to increase the conductivity of the electrically conductive patterns on said surface.

In this heating step conventional heating methods can be used, but preferably the temperatures used in these conventional methods are chosen not to deteriorate the substrate used in the single case. This additional step iii) increases the electrical conductivity already developed during step ii). But this step iii) is optional. In another embodiment of the process of this invention the development of electrical conductive patterns by transformation of the metal precursor into metal is exclusively performed by using one or more plasma treatment steps.

In the process of this invention generally each substrate can be used. In view of the mild conditions also substrates can be used which have not been used sucessfully in the past.

A large variety of substrates can be chosen for the method of this invention. Non limiting examples are polymers (thermoplastic and duroplastic polymers including elastomers); inorganic materials, such as ceramic materials; semi-conducting substrates, such as silicon or gallium-arsenide, fibrous substrates containing natural and/or man-made fibers, such as paper, textile sheets including non-wovens; film and sheet materials made from polymers and or natural materials, such as leather, wood or thermoplastic sheet or bulk materials including composites containing said sheet or bulk materials.

Suitable substrates can possess a large variety of properties. For example, they can be transparent or non-transparent, or they can be crystalline or non-crystalline or they can contain adjuvants, such as pigments, antistatic agents, fillers, reinforcing materials, lubricants, processing aids and heat and/or light stabilizers.

Preferred substrates are thermoplastic polymers, such as polyesters (e.g. polyethylene terephthalate), polyamides, polyimides, polyether-imides, polycarbonates, polyolefins (e.g. polyethylene or polypropylene), polyetherketones, polysiloxanes and polyarylenesulphides, such as polyphenylenesulphide.

As material forming the surface pattern in general each metal precursor which can be converted into the metal upon plasma treatment can be used. Examples of materials which may be used for forming the surface pattern are metal complexes or metal salts or other metal precursor compounds that can be formulated as an ink.

Preferably precursors of noble metals and/or metals of the platinum group and/or of the copper group are used.

Preferably precursors of gold, precursors of copper and especially preferred precursors of silver or combinations of precursors of silver and other metals are used.

The metal precursors are preferably applied in the form of an ink to the surface. Metal precursors are used as solutions or dispersions in a solvent.

The surface of the substrate may be coated with a metal precursor by applying a dispersion or a solution containing said metal precursor in a liquid onto said surface.

Different coating methods can be used as long as these allow the coating of a surface by creation of a predetermined surface pattern. Predetermined surface patterns can be layers covering the whole surface or other forms of surface coverage. Preferably surface patterns cover portions of the surface, for example in the form of tracks and/or of isolated spots of metal precursor. Several surfaces of the substrate can be coated. For example two surfaces of a sheet material can be coated in the form of tracks which are optionally connected via holes going through the substrate and containing conductive material.

Examples of coating methods are known in the art of applying surface coatings, such as curtain coating, spin-coating, drop casting or coating by means of doctor blade.

Preferably printing methods methods are used, such as offset printing or screen printing and very preferred ink-jet printing.

Initially, the coating material that forms the patterns on said surface(s) is present as a dispersion or solution of a metal precursor in a carrier material that renders the coating material pasty or preferably fluid. The pasty coating material is hereafter referred to as "paste". The fluid coating material is hereafter referred to as "ink".

The paste or ink is applied to the surface of the substrate to form a pattern after drying by means of a printing technique, more particularty ink-jet printing.

When applying the paste or ink to the surface of the substrate the carrier material can be removed at the same time, for example by heating the substrate and by chosing a carrier material that evaporates or decomposes at the substrate temperature. In an alternative or an additional step the carrier material can be evaporated or decomposed after the formation of the surface pattern in a separate heat treatment step.

After a predetermined pattern of a metal precursor has been formed on the substrate surface(s) this is then exposed to a plasma.

Different plasma treatments are possible as long as these are capable to convert the metal precursor into the metal.

Examples of plasmas for plasma treatment are thermal plasmas or preferably non-thermal plasmas which can be used at high, atmospheric or low pressures. Different gases can be used for plasma formation. Examples thereof are inert gases, such as nitrogen or noble gases, like helium, argon or xenon, or oxidative gases, like oxygen or oxygen-containing gases, such as air, or gaseous hydrocarbons, like methane or ethane.

Different methods for plasma formation can be used. Examples thereof are thermal activation by collision ionisation, chemical activation, activation by electric fields, by direct current voltage, and preferably activation by means of electromagnetic fields, for example by electromagnetic radiation, such as microwave radiation or laser radiation.

Preferably a low-pressure plasma using a carrier gas is used, very preferably a noble gas or nitrogen.

As an optional but preferred step a heat treatment of the plasma-treated substrate containing a pattern of released metal on the surface can be performed. This in general increases the electrical conductivity of the metal pattern formed on the substrate surface.

Different heat treatment methods can be used. For example, the substrate containing the metal pattern can be heated in a convection oven, by means of a laser, by means of microwaves, by means of field assisted sintering or by means of pulse current electric sintering.

The equipment for performing the method of this invention can be chosen from known devices. Coating devices, plasma treatment devices and heat treatment devices are known in the art and commercially available.

The invention also relates to a device for performing the above-defined method comprising the combination of
A) a coating device for surface coating of a substrate with a predetermined pattern of a metal precursor, and
B) a plasma generator to generate a plasma which contacts the coated substrate surface to convert the metal precursor into the metal.

As a coating device A) preferably an ink-jet printer can be used.

As a plasma generator B) preferably a plasma asher operating in the radio-frequency range can be used, most preferably in the range from kHz to MHz.

The processed substrates containing conductive surface patterns of metal can be compiled to form a layered product with several substrates possessing conductive patterns in the interior and on the surface. The layered products can contain layers of other materials besides the processed substrates containing conductive surface patterns of metal.

Furthermore, the invention relates to the use of a plasma to create electrically conductive surface patterns from a metal precursor deposited on the surface of a substrate.

The process for generating electrically conductive surface patterns on a substrate surface can be used, for example, for the production of printed wiring boards or of integrated circuits, for the production of decorative sheets or for the production of of data recording or of data storing media, for the production of print boards, for the production of radio frequency identification devices (RFID devices), for the production of organic light emitting devices (OLED), for the production of thin-film transistors (TFT) or for the production of electrical devices, like heating elements, resistors, coils or antennae. These uses are also object of the present invention.

The following Example illustrates the invention without any limitation.

### Example

A silver salt solution in methanol / anisole was purchased form InkTec (TEC IJ-040, InkTec Co., Ltd., Korea). The colorless and transparent silver ink contained 20 % by weight of silver. Inkjet printing was performed using an Autodrop printer (Microdrop Technolgies GmbH) equipped with an unheated 70 µm piezoelectrically actuated nozzle. The ink was printed at room temperature and with the following settings: voltage 96 V and a puls width of 46 µs, while maintaining an underpressure of 6 mbar. The droplet volume was approximately 180 pL. Dot spacing was chosen to be 100 µm. Arrays of 5 lines, having a length of 15 mm and interspacing of 1.5 mm, were prepared.

Sintering studies were carried out utilizing commercial microscopy slides, which were cleaned follwing standard procedures. Plasma post treatment was carried out using a commercial low-pressure plasma asher (K1050X, Emitech). Supplied RF power could be set to a value between 0 and 100 W at 1.56 MHz. After pump down to 0.6 mbar, the carier gas was led into the chamber at 40 Psi for 250 s yielding a working pressure of 1 mbar.

The resistance of the conducting silver tracks was measuerd by the 2-point method. The electrical resistivity p of an inkjet printed line was calculated from the resistance R, the length A, and the cross sectional area A of the line, using p = R * A / λ. The cross-sectional area was determined by numerical integration of a measured profile, which was measured using an optical profilometer (Fogale Zoomsurf).

Plasma treatment was carried out using argon gas. Power was chosen to be either 40 W, 60 W and 80 W, respectively. Processing times were chosen to be 5, 20 and 60 minutes. The samples were placed centrically onto the electrically isolated sample holder. Within the first 5 minutes of exposure the tracks were already rendered conductive. The obtained resistivity values were 2 to 3 orders higher than that of bulk silver. However, when the sintering times were extended to 20 minutes or longer, the resistivity had dropped to a value of approximately 2*10⁻⁷ Ohms*m, which is only 1 order of magnitude higher than bulk silver.

At higher power (60 and 80 W) the resistitvity was lower after the first 5 minutes compared to 40 W, whereas longer sintering times had a relatively small effect on the resistivity. A higher power created a larger amount of charged species that can more easily dissociate the organic moiety. As reduction occured, metal atoms were released from the complexes and growed through Ostwald ripening into larger agglomerates, such as nanoparticles and subsequently into dense films. Therefore, if the organic moiety was partly decomposed into smaller volatile compounds by the plasma exposure, nucleation of the reduced metal ions took place.

## Claims

1. A process for generating electrically conducting surface patterns on a substrate surface comprising the steps:
i) coating a surface of a substrate with a predetermined pattern of a metal precursor,
ii) exposing the coated substrate to a plasma to convert the metal precursor into the metal and to form electrically conductive patterns on said surface.

2. A process as claimed in claim 1, wherein the plasma treated coated substrate is heated in step iii) to increase the conductivity of the electrically conductive patterns on said surface.

3. A process as claimed in claim 1, wherein the surface of the substrate is coated with a predetermined pattern of a metal precursor by applying a solution of said metal precursor in a solvent onto said surface and by drying said coated substrate to cause said solvent to evaporate.

4. A process as claimed in claim 3, wherein the metal precursor is a metal salt or a metal complex, preferably a gold salt, a copper salt, a silver salt or a combination thereof or preferably a gold complex, a copper complex, a silver complex or a combination thereof.

5. A process as claimed in any of the claims 1 to 4, wherein as a coating method a printing method is used, preferably ink-jet printing.

6. A process as claimed in any of the claims 1 to 5, wherein the plasma is low-pressure plasma using a carrier gas, preferably a noble gas or nitrogen.

7. A process as claimed in any of the claims 2 to 6, wherein the heating step iii) is conducted in a convection oven, by means of laser heating, by means of microwave heating, by field assisted sintering or by pulse current electric sintering.

8. A device for performing the process of claim 1 comprising the combination of
A) a coating device for surface coating of a substrate with a predetermined pattern of a metal precursor, and
B) a plasma generator to generate a plasma which contacts the coated substrate surface to convert the metal precursor into the metal.

9. A device as claimed in claim 8, wherein the coating device is an ink-jet printer.

10. A device as claimed in claim 8, wherein the plasma generator B) is a plasma asher operating in the radio-frequency range.

11. Use of a plasma to create electrically conductive surface patterns from a metal precursor deposited on the surface of a substrate.

12. Use of the process according to any of the claims 1 to 7 for the production of printed wiring boards or of integrated circuits, for the production of decorative sheets, for the production of of data recording or of data storing media, for the production of print boards, for the production of radio frequency identification devices (RFID devices), for the production of organic light emitting devices (OLED), for the production of thin-film transistors (TFT) or for the production of electrical devices, preferably of heating elements, resistors, coils or antennae.
